# EUROPEAN PATENT APPLICATION

(11) **EP 4 831 859 A1**
(43) Date of publication of application: **28.10.2026**
(21) Application number: 25172625.3
(22) Date of filing: 25.04.2025
(51) Int. Cl.: G06F 30/20

(54) **SYSTEM AND METHOD FOR GENERATING ONE OR MORE VIRTUAL WORLDS FOR TRANSTEMPORAL EXPERIENCE IN A COMPUTER-SIMULATED ENVIRONMENT**

(71) Applicant: Siemens Aktiengesellschaft, 80333 München (DE)
(72) Inventor: Mondal, Chittapriya, 560061 Bangalore, Karnataka (IN); Ray, Arun, 635110 Hosur, Tamil Nadu (IN)
(74) Representative: Patentanwaltskanzlei WILHELM & BECK

(57) **Abstract**

Disclosed is system (100, 600) and method (300) for generating virtual worlds (104) for transtemporal experience in computer simulated environment (102). The method comprises importing, by processing unit (202), simulation scenario pertaining to operation and behavior of assets for present time, acquiring information pertaining to operation of assets from large language models (510, 610) for past time; simulating operation and behavior of the assets by updating a first set of simulation parameters determined based on acquired data, analyzing simulation scenario generated time in past; determining second set of simulation parameters corresponding to simulation scenarios for future time based on analysis of past simulation scenarios and requirements from user, using a generative AI model (612), simulating plurality of future versions of simulation scenarios based on determined second set of simulation parameters; and rendering, simulation scenarios as virtual worlds of future and past to be visualized by user (504, 506, 606).

## Description

The present disclosure relates to computer simulated environments, and more particularly relates to a computer-implemented method for generating one or more virtual worlds for transtemporal experience in a computer simulated environment.

The metaverse can be described as a virtual universe comprising shared, three-dimensional virtual spaces where users can own, place, and interact with virtual assets. In the industrial environment, this concept has led to the development of the "industrial metaverse," where virtual spaces often serve as digital replicas of real-world industrial locations such as factories, wind turbine farms, and power generation facilities. Significant efforts have been directed towards creating accurate representations of these real-world industries within the metaverse and connecting them with real-time sensor data to establish interactive digital twins.

While the creation of interactive digital twins representing the present state of industrial environments is a significant advancement, it represents only one facet of potential interaction within the industrial metaverse. There is a growing emphasis on sustainability and long-term planning within the industrial sector. Consider, for instance, a thermal power plant. Given the global shift towards greener energy sources, such a plant might become functionally obsolete in the coming years or decades. This necessitates crucial decisions regarding the future of the site. If, for example, the location was originally a biodiverse forest a century ago, there might be a desire to restore it to its former ecological state. However, the information and data required to make such informed decisions about long-term site evolution and restoration are often lacking.

The ability to experience the entire lifecycle of an industrial location within the metaverse - from its past state (e.g., a forest), through its present form (e.g., a power plant), to its potential future states (e.g., an abandoned structure or a restored ecosystem) - would provide invaluable context for decision-makers, even those without specialized expertise. By experiencing this transtemporal evolution, stakeholders can gain a deeper understanding of the long-term implications of industrial activities and make more informed choices about the future. Such a transtemporal experience in the industrial metaverse holds significant potential benefits across a wide range of applications, including enhanced customer expositions, engaging educational exhibits for students, improved factory planning and optimization strategies, and more effective long-term sustainability initiatives.

The primary challenge in realizing this lies in the inherent unavailability of comprehensive data required to accurately create and render such transtemporal experiences within the metaverse. There is a scarcity of comprehensive and detailed historical data for industrial sites, particularly extending back many decades or centuries. Information about the original natural environment, early industrial activities, and the gradual transformation of the site may be incomplete, fragmented, or non-existent.

Another major challenge in realizing such a system is complexity of future predictions. Data from different historical periods is likely to have been collected using disparate technologies (e.g., manual records, early surveys, satellite imagery) and stored in incompatible formats. Integrating this heterogeneous data into a unified and coherent metaverse experience presents a complex technical challenge.

Furthermore, accurately forecasting the future evolution of an industrial site involves numerous uncertainties and influencing factors, such as technological advancements, economic shifts, evolving environmental regulations, and societal priorities. Currently, generating realistic and informative future scenarios requires sophisticated simulation models capable of handling these complexities.

Moreover, another challenge in state-of-the-art techniques is that current systems do not visually represent the same geographic location across vastly different time epochs within an interactive metaverse environment with detail, ease and accuracy. Accurately modeling diverse environments (e.g., natural landscapes versus industrial complexes), managing variations in scale and level of detail, and ensuring a seamless and intuitive user experience when transitioning between different temporal representations are critical technical hurdles.

Addressing these challenges is crucial to enable truly impactful transtemporal experiences for informed decision-making and enhanced understanding for industrial environments.

In the light of the above, there exists a need to provide a computer-simulated industrial environment and a method for generating one or more virtual worlds via reconstructing past environments and predicting plausible future scenarios using data acquisition, simulation, and visualization techniques for a transtemporal experience.

Therefore, it is an object of the invention to provide a method for generating one or more virtual worlds for transtemporal experience in a computer simulated environment.

Throughout the present disclosure, the term "transtemporal experience" for the user can be defined as an ability provided to the user within the metaverse application to visualize and interact with the virtual worlds across different point in time, encompassing past, present and future states. The term "transtemporal" refers to representing same geographic location across vastly different time epochs, or in other words, the same scenario across different periods of time to provide a transtemporal experience. These transtemporal experiences allow the user to observe the evolution of the industrial environment and assets therein through time, facilitating a comprehensive understanding of its lifecycle, historical context, and potential future trajectories, thereby supporting informed decision-making and enhanced comprehension.

The term "industrial environment" as used herein refers to any environment comprising one or more assets interacting therein. The term industrial environment may refer to any building such as a factory or any type of manufacturing facility, an office building or the like, which may be populated with various entities. Herein, the term "industrial environment" refers to the whole of machineries or parts thereof which cooperate to allow a production process of any kind to be carried out. Example of industrial environment may be any industrial set-up with a plurality of assets such as a power plant, wind farm, power grid, manufacturing facility, process plants and so on. Although the present disclosure has been described generally in terms of the industrial environment being some form of a factory floor, the term "industrial environment" as used in the preferred embodiments and claims according to the present disclosure should be understood broadly to include not only factory floors, but also other indoor facilities and buildings such as hospitals, office spaces, apartments, complexes, schools, training centers, and so forth. The term "industrial environment" may also include other outdoor facilities such as a parking lot, a traffic junction, and vehicles such as airplanes, ships and trucks.

Throughout the present disclosure, the term "one or more assets" as used herein refers to any device, system, instrument, or machinery manufactured or used in an industry that may be employed for performing an operation. Example of assets include any machinery in an industrial environment or technical installation/facility such as motors, gears, bearings, shafts, switchgears, rotors, circuit breakers, protection devices, remote terminal units, transformers, reactors, disconnectors, gear-drive, gradient coils, magnets, radio frequency coils etc. The one or more assets may also include automated systems such as automated robots, semi-automated robots, remote-controlled robots, robotic arms, etc. that are employed in the industrial environment to perform an operation or task. Exemplary technical systems include turbines, large drives, Magnetic Resonance Imaging (MRI) scanner, etc. Example facility/technical installation may be a complex industrial set-up with a plurality of assets such as a power plant, wind farm, power grid, manufacturing facility, process plants and so on. In view of the present invention, the industrial environment maybe comprised of simple assets and complex assets. The simple assets in the industrial environment are characterized by straightforward design and less complexity of processing of the images acquired. In contrast, the complex assets are characterized by complex designs and higher complexity of processing of the complex asset. In an example, simple assets are boxes, tools, pumps, sensors, operators, etc. and the complex assets are turbines, motors, CNC machines, cranes, etc.

Throughout the present disclosure, the term "virtual worlds" refer to simulated digital environment that is created to mimic reality. Within the virtual world, users can interact with the environment and participate in real-time interactions. Users, represented as avatars, can navigate the virtual world, manipulate objects, engage in activities, communicate with others, and create or modify the virtual world itself. The virtual worlds mimic the "real worlds", physical world or the natural world. In the real world, events occur naturally, and phenomena are governed by physical laws, scientific principles, and observable patterns.

Throughout the present disclosure, the term "computer simulated environment" as used herein refers to three-dimensional (3D) representation of a real or physical world. It can be understood as a virtual world. The computer-simulated environment is accessible by a user, i.e., it is accessible from the real/physical world. This comprises data exchange between the computer-simulated environment and the real/physical world. In particular, the computer-simulated environment can be understood as the "metaverse" or the "industrial metaverse". It is also possible to interact with the computer-simulated environment, i.e., to influence or use processes, components and/or functions in the computer-simulated environment. Therefore, processes in the computer-simulated environment may have direct influence on processes in the real/physical world, e.g., by modelling control processes virtually.

For example, it is possible that a user can access the computer-simulated environment via an interface, e.g., a virtual reality (VR) or augmented reality (AR) interface. The counterpart of the computer-simulated environment does not necessarily have to exist but can be for example a 3D model. It is also possible that physical forces and phenomena, e.g., gravity, are represented in a different way in the computer-simulated environment than in the real world, e.g., gravitational acceleration. For the purpose of this invention, the metaverse is comprised of one or more animated scenes being rendered corresponding to the plurality of assets interacting in the industrial environment.

The metaverse may comprise a plurality of computer-simulated components. The computer simulated components can for example be understood as a representation, in particular a 3D representation, of a real or physical component. A component can for example be a room, a building, an item, or an object. The computer-simulated component can have different functionalities/features, e.g., an access interface. The computer-simulated component further comprises data that are component-specific, e.g., sensor data of a virtual sensor, that can be retrieved for example via the access interface. An access to a computer-simulated component can for example comprise usage, modification, connection to other computer-simulated components, etc. The computer-simulated component can interact with the computer-simulated environment. For the purpose of this invention,

The metaverse can be realized by a hosting environment. The hosting environment can be for example be implemented as a cloud environment, an edge-cloud environment and/or on specific devices, e.g., mobile devices.

Throughout the present disclosure, the term "user" as used herein refers to any person, avatar, virtual assistant, or any other device or system configured to raise request to the apparatus for viewing the complex digital twins and interacting therewith.

The object of the present invention is achieved by a method for generating one or more virtual worlds for transtemporal experience in a computer simulated environment. The method comprises importing a simulation scenario pertaining to operation and behavior of one or more assets in an industrial environment, wherein the simulation scenario comprises data acquired for a present time t0. The method comprises acquiring information pertaining to the operation and operation of the one or more assets from one or more large language models for a particular time t-1 in the past. The method comprises simulating the operation and behavior of the one or more assets by updating a first set of simulation parameters determined based on the acquired data, in the imported simulation scenario. The method comprises analyzing the simulation scenario generated for the particular time in the past. The analysis is performed on the operating parameters, performance of the assets, and corresponding impact on environmental factors for the time period between the particular time past to the given time in present using the large language model. The method comprises determining a second set of simulation parameters corresponding to simulation scenarios for a particular time in future t+1 based on the analysis of the past simulation scenarios and one or more requirements from the user, using a generative Al model trained for generating new scenarios based on one more conditions. The method comprises simulating plurality of future versions of the simulation scenarios based on the determined second set of simulation parameters. The method comprises rendering the one or more simulation scenarios as virtual worlds of the future and the past to be visualized by the user.

In an embodiment, the method comprises selecting an optimal future scenario from the plurality of future scenarios based on one or more requirements of the user and a criterion of least negative environmental impact predicted in the optimal simulation scenario.

In an embodiment, the method comprises determining a timeline of events within the optimal simulation scenario. The timeline of events corresponds to industrial environment change from the present state to the final optimal future state.

In an embodiment, the method comprises determining one or more measures and corresponding optimal operating parameters across the timeline of events, which when executed on the real-world industrial data, would yield the output of the optimal future scenario.

In an embodiment, the method comprises generating a project plan for a particular time period. The implementation of the determined parameters and recommended measures within the project plan leads to achieving the state of the optimal future scenario.

In an embodiment, the method comprises receiving one or more requirements from the user to generate a virtual world for a particular time. Further, the method comprises simulating the imported simulation scenario with one or more simulation parameters determined for the particular time. Further, the method comprises rendering the simulation scenario to the particular user.

In an embodiment, the method comprises storing the generation future scenarios in a database indexed with time and corresponding operation parameters for the given time.

In an embodiment, the method comprises rendering further comprises generating a timelapse experience for the user for a given time period simulating the series of events therebetween.

In an embodiment, the method comprises storing different versions of generated simulation scenarios created by different users, wherein each version is associated with user credentials and is accessible only to the corresponding user.

The object of the invention is also achieved by an apparatus for generating one or more virtual worlds for transtemporal experience in a computer simulated environment. The apparatus comprises one or more processing units, memory communicatively coupled to the one or more processing units. The memory comprises a module stored in the form of machine-readable instructions executable by the one or more processing units. The module is configured to perform the aforementioned method steps.

The object of the invention is also achieved by a system for generating one or more virtual worlds for transtemporal experience in a computer simulated environment. The system is a computer simulated environment hosting a plurality of virtual worlds, wherein each of the virtual worlds correspond to a version of operation of one or more assets in an industrial environment at a given point in time. The system further comprises an apparatus. The apparatus is communicatively coupled to the computer simulated collaborative environment. The apparatus is configured for generating one or more virtual worlds for transtemporal experience in a computer simulated environment according to the aforementioned method steps.

The object of the invention is also achieved by a computer program product comprising machine readable instructions, that when executed by one or more processing units, cause the one or more processing units to perform the aforementioned method steps.

The present invention is further described hereinafter with reference to illustrated embodiments shown in the accompanying drawings, in which:
- FIG 1: illustrates a block diagram of a system for generating one or more virtual worlds for transtemporal experience in a computer simulated environment, according to an embodiment of the present invention;
- FIG 2: illustrates a block diagram of an exemplary apparatus for generating one or more virtual worlds for transtemporal experience in a computer simulated environment, according to an embodiment of the present invention;
- FIG 3: illustrates a flowchart of a method for generating one or more virtual worlds for transtemporal experience in a computer simulated environment, according to an embodiment of the present invention;
- FIG 4: illustrates a representation of different version of virtual worlds created based on user inputs, according to an embodiment of the present invention;
- FIG 5: illustrates a workflow of management of different version of the simulated virtual worlds, according to an embodiment of the present invention; and
- FIG 6: illustrates an exemplary architecture of the system for generating one or more virtual worlds for transtemporal experience in a computer simulated environment.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

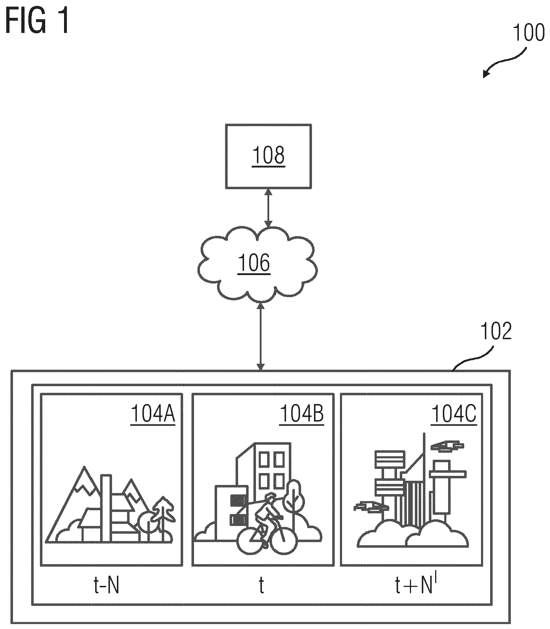

FIG 1 is a block diagram of a system 100 for generating one or more virtual worlds for transtemporal experience in a computer simulated environment. The system 100 comprises a computer simulated environment 102 (or sometimes referred to as "metaverse application" hereinafter), one or more virtual worlds 104A, 104B, 104C (collectively referred to as 104 hereinafter) rendered in the computer simulated environment 102, an apparatus 108 communicating over a communication network 106. The computer simulated environment 102 is three-dimensional (3D) representation of a real or physical world. It can be understood as a virtual space representing one or more virtual worlds 104 rendering one or more real-world assets (not shown) in an industrial environment. The term "industrial environment" as used herein refers to any industrial environment comprising one or more assets interacting therein. The term industrial environment may refer to any building such as a factory or any type of manufacturing facility, an office building or the like, which may be populated with various assets. Herein, the term "factory" or industrial environment refers to the whole of machineries or parts thereof which cooperate to allow a production process of any kind to be carried out. Example of factory may be any industrial set-up with a plurality of assets such as a power plant, wind farm, power grid, manufacturing facility, process plants and so on. Although the present disclosure has been described generally in terms of the industrial environment being some form of a factory floor, the term "industrial environment" as used in the preferred embodiments and claims according to the present disclosure should be understood broadly to include not only factory floors, but also other indoor facilities and buildings such as hospitals, office spaces, apartments, complexes, schools, training centers, and so forth. The term "industrial environment" may also include other outdoor facilities such as a parking lot, a traffic junction, and vehicles such as airplanes, ships and trucks.

The term "virtual worlds" 104 as used herein refers to simulated digital environment that is created to mimic reality. Within the virtual world, users can interact with the environment and participate in real-time interactions. Users, represented as avatars, can navigate the virtual world, manipulate objects, engage in activities, communicate with others, and create or modify the virtual world itself. The virtual worlds 104 mimic the "real worlds", physical world or the natural world. In the real world, events occur naturally, and phenomena are governed by physical laws, scientific principles, and observable patterns. It is to be noted that the term "simulation scenario" and "virtual worlds" are sometimes used interchangeably hereinafter.

In the context of the present invention, the virtual worlds 104 can be understood as a computer-generated, three-dimensional, immersive digital environments within the metaverse application 102, representing the industrial environment at a specific point in time, whether past, present or future. The virtual worlds 104 are created based on simulation scenarios generated by the proposed method and allow the user to visualize and interact with digital representations of the industrial assets, their operation, and the surrounding environment as they existed, exist, or are predicted to exist at that particular time. As shown, in an example, the virtual worlds 104A, 104B and 104C are rendered to the user. The virtual world 104A is simulated and rendered to the user for a instance 't-N', the virtual world 104B is rendered to the user for an instance 't', and the virtual world 104C is rendered to the user for an instance 't+N''. It should be noted that throughout the present disclosure, time 't' is referred to as a present point in time, time 't-N' is referred to as past point in time, and time 't+N'' is referred to as a future point in time. Furthermore, it should be understood that 't' could be a time, date, year based on an input preference of the user. The virtual worlds 104 are comprised of one or more virtual assets that represent the one or more assets in the industrial environment. The one or more virtual assets (not shown) are 3-dimensional models of assets that are implemented in the industrial environment. The rendered 3-dimensional models of the assets are imported as a simulation in the computer simulated environment. The computer-simulated environment is accessible by a user, i.e., it is accessible from the real/physical world. In particular, the computer-simulated environment 102 can be understood as the "metaverse". It is also possible to interact with the computer-simulated environment 102, i.e., to influence or use processes, components and/or functions in the computer-simulated environment. The user or the avatar interacts with the virtual assets or virtual worlds 104 rendered in the metaverse 102.

For example, it is possible that a user accesses the computer-simulated environment 102 via an interface, e.g., a virtual reality (VR) or augmented reality (AR) interface. For the purpose of this invention, the metaverse 102 is comprised of one or more animated scenes being rendered corresponding to the plurality of assets interacting in the industrial environment. The metaverse 102 may comprise a plurality of computer-simulated components. The computer simulated components can for example be understood as a representation, in particular a 3D representation, of a real or physical component. A component can for example be a room, a building, an item, or an object. The computer-simulated component can have different functionalities/features, e.g., an access interface. The metaverse 102 can be realized by a hosting environment. The hosting environment can be for example be implemented as a cloud environment, an edge-cloud environment and/or on specific devices, e.g., mobile devices.

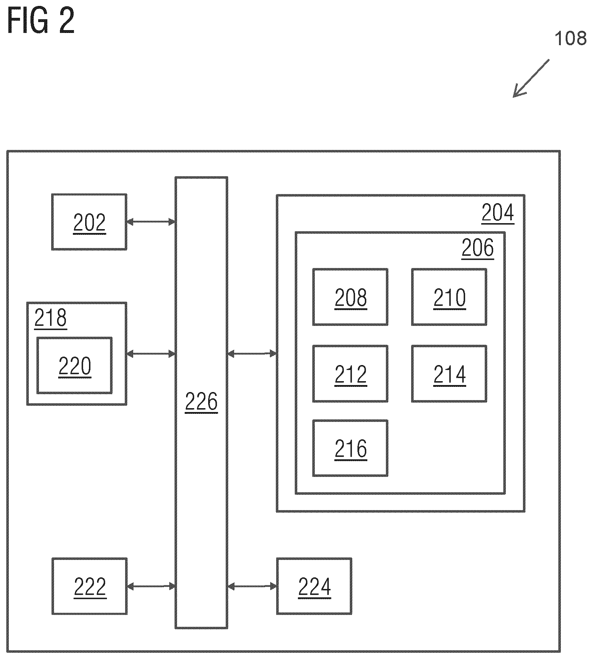

In one embodiment, the apparatus 108 is deployed in a cloud computing environment. As used herein, "cloud computing environment" refers to a processing environment comprising configurable computing physical and logical resources, for example, networks, servers, storage, applications, services, etc., and data distributed over the network, for example, the internet. The cloud computing environment provides on-demand network access to a shared pool of the configurable computing physical and logical resources. The apparatus 108 includes a processing unit, and a module (as shown in FIG 2) for generating one or more virtual worlds for transtemporal experience in a computer simulated environment 102.

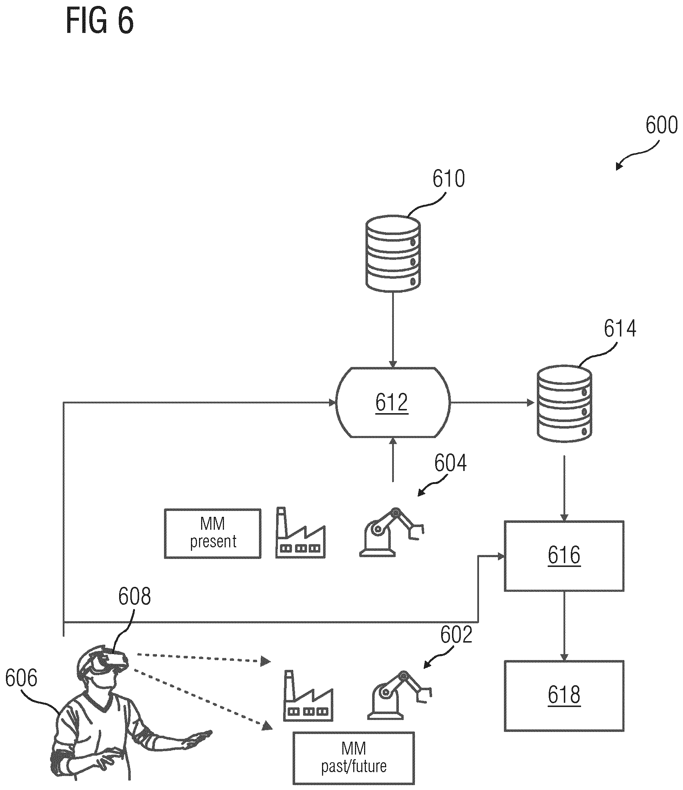

In an exemplary embodiment, the virtual worlds 104 are rendered to the user (as show in FIG 6) via a wearable device (as shown in FIG 6). The user is equipped with the wearable device configured for visualization of the simulation of one or more virtual worlds 104A, 104B, 104C in the computer simulated environment 102. In an example, the wearable device comprises a display module that presents visual information to the user, rendering one or more virtual worlds 104 via reconstructing past environments and predicting plausible future scenarios using data acquisition, simulation, and visualization techniques for a transtemporal experience, in a realistic and immersive manner. The display module may include a high-resolution screen, holographic display, augmented reality (AR) glasses, or any other suitable technology for visually presenting virtual content to the user. Additionally, the wearable device incorporates a tracking system to capture the user's movements and gestures, allowing for real-time interaction and navigation within the metaverse. The tracking system may utilize sensors, cameras, motion trackers, or any other suitable means of capturing and interpreting user movements. Furthermore, the wearable device includes connectivity features to facilitate communication and data exchange with the metaverse infrastructure. These features may include wireless communication capabilities, such as Wi-Fi, Bluetooth, or cellular connectivity, enabling the wearable device to connect to the metaverse platform, retrieve asset data, and transmit user actions or preferences. The wearable device may also incorporate input mechanisms, such as touch-sensitive surfaces, buttons, voice recognition, or motion sensors, allowing users to provide commands, make selections, or manipulate virtual assets within the metaverse environment. The wearable device for visualizing complex assets in the metaverse is designed to enhance the user's experience and immersion in the virtual world. It enables users to perceive, interact with, and navigate through virtual worlds, virtual assets, objects, and environments seamlessly, thereby providing a novel and immersive way to explore and visualize digital content within the metaverse.

FIG 2 is a block diagram of an exemplary apparatus 108 for generating one or more virtual worlds for transtemporal experience in a computer simulated environment 102, according to an embodiment of the present invention. In an exemplary embodiment, the apparatus 108 is communicatively coupled to the computer simulated environment 102 rendering one or more virtual worlds 104A at time 't-N', 104B at time 't', and 104C 't+N''

The apparatus 108 may be a personal computer, a laptop computer, a tablet, a server, a virtual machine, and the like. The apparatus 108 includes a processing unit 202, a memory unit 204 comprising a module 206, a storage unit 218, an input unit 222, a display unit 224 and a bus 226.

The processing unit 202 as used herein, means any type of computational circuit, such as, but not limited to, a microprocessor, microcontroller, complex instruction set computing microprocessor, reduced instruction set computing microprocessor, very long instruction word microprocessor, explicitly parallel instruction computing microprocessor, graphics processor, digital signal processor, or any other type of processing circuit. The processing unit 202 may also include embedded controllers, such as generic or programmable logic devices or arrays, application specific integrated circuits, single-chip computers, and the like.

The memory unit 204 may be non-transitory volatile memory and/or non-volatile memory. The memory may be coupled for communication with the processing unit 202, such as being a computer-readable storage medium. The processing unit 202 may execute instructions and/or code stored in the memory unit 204. A variety of computer-readable instructions may be stored in and accessed from the memory. The memory unit 204 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

In the present embodiment, the memory unit 204 includes the module 206 stored in the form of machine-readable instructions on any of the above-mentioned storage media and may be in communication to and executed by the processing unit 202. When the machine-readable instructions are executed by the processing unit 202, the module 206 causes the processing unit 202 to generate and render one or more virtual worlds for a transtemporal experience to the user.

The module 206 further comprises a scenario importing module 208, data collection module 210, data analysis module 212, simulation module 214, and rendering module 216.

The scenario importing module 208 is configured for importing a simulation scenario pertaining to operation and behavior of one or more assets in an industrial environment. The simulation scenario comprises data acquired for a present time 't' pertaining to the assets in the industrial environment operating at the present time.

The data collection module 210 is configured for acquiring information pertaining to the operation and behavior of the one or more assets from one or more large language models for a particular time 't-N' in the past. The data collection module acquires data from the pre-trained large language models.

The data analysis module 212 is configured for analyzing the simulation scenario generated for the particular time in the past. The analysis is performed on the operating parameters, performance of the assets, and corresponding impact on environmental factors for the time period between the particular time in past to the given time in present using the large language model.

The simulation module 214 is configured for simulating the operation and behavior of the one or more assets by updating a first set of simulation parameters determined based on the acquired data, in the imported simulation scenario. Further, the simulation module 214 is configured for determining a second set of simulation parameters corresponding to simulation scenarios for a particular time in future 't+N' based on the analysis of the past simulation scenarios and one or more requirements from the user, using a generative Al model trained for generating new scenarios based on one or more conditions. Further, the simulation module 214 is configured for simulating plurality of future versions of the simulation scenarios based on the determined second set of simulation parameters.

The rendering module 216 is configured for rendering the one or more simulation scenarios as virtual worlds 104 of the future and the past to be visualized by the user.

The processing unit 202 is configured for performing all the functionality of the module. The processing unit 202 is configured for importing a simulation scenario pertaining to operation and behavior of one or more assets in an industrial environment, wherein the simulation scenario comprises data acquired for a present time 't'. The processing unit 202 is configured for acquiring information pertaining to the operation and behavior of the one or more assets from one or more large language models for a particular time 't-N' in the past. The processing unit 202 is configured for simulating the operation and behavior of the one or more assets by updating a first set of simulation parameters determined based on the acquired data, in the imported simulation scenario. The processing unit 202 is configured for analyzing the simulation scenario generated for the particular time in the past, wherein the analysis is performed on the operating parameters, performance of the assets, and corresponding impact on environmental factors for the time period between the particular time past to the given time in present using the large language model. The processing unit 202 is configured for determining a second set of simulation parameters corresponding to simulation scenarios for a particular time in future 't+N' based on the analysis of the past simulation scenarios and one or more requirements from the user, using a generative Al model trained for generating new scenarios based on one more conditions. The processing unit 202 is configured for simulating plurality of future versions of the simulation scenarios based on the determined second set of simulation parameters. The processing unit 202 is configured for rendering the one or more simulation scenarios as virtual worlds 104 of the future and the past to be visualized by the user.

The storage unit 218 comprises the database 220. The database may be configured for storing complex digital twins, simulation parameters, simulation scenarios, one or more virtual worlds, different versions of the virtual worlds and so forth. The database 220 may be provided using various types of storage technologies, such as solid-state drives, hard disk drives, flash memory, and may be stored in various formats, such as relational databases, non-relational databases, flat files, spreadsheets, and extended markup files, etc.

The input unit 222 may provide ports to receive input from input devices such as keypad, touch-sensitive display, camera (such as a camera receiving gesture-based inputs), etc. capable of receiving set of requirements for rendering one or more virtual worlds, one or more environmental conditions, time period, etc.. The display unit 224 may provide ports to output data via output device with a graphical user interface for displaying one or more virtual worlds in the computer simulated virtual environment. The bus 226 acts as interconnection between the processing unit 202, the memory 204, the storage unit 218, the input unit 222, and the display unit 224.

Those of ordinary skilled in the art will appreciate that the hardware depicted in FIG 2 may vary for particular implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter also may be used in addition to or in place of the hardware depicted. The depicted example is provided for the purpose of explanation only and is not meant to imply architectural limitations with respect to the present disclosure.

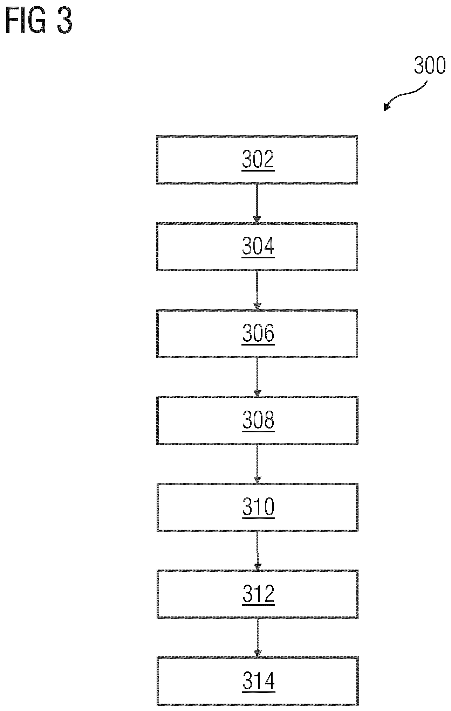

FIG 3 illustrates a flowchart of a method 300 for generating one or more virtual worlds 104 for transtemporal experience in a computer simulated environment 102, according to an embodiment of the present invention.

The method provides virtual representations of an industrial environment as it existed in the past and as it is projected to exist in the future within the metaverse 102. The term "transtemporal experience" for the user can be defined as an ability provided to the user within the metaverse application to visualize and interact with the virtual worlds across different point in time, encompassing past, present and future states. These experiences allow the user to observe the evolution of the industrial environment and assets therein through time, facilitating a comprehensive understanding of its lifecycle, historical context, and potential future trajectories, thereby supporting informed decision-making and enhanced comprehension.

At step 302, a simulation scenario pertaining to operation and behavior of one or more assets in an industrial environment is imported. The simulation scenario comprises data acquired for a present time 't'. This method comprises loading an initial digital representation of the industrial environment as it currently exists. The "simulation scenario" is a comprehensive dataset that emulates a state and operational characteristics of various assets within the industrial environment. The data within this scenario can be structured in various formats depending on the simulation platform or software being utilized. The data from the simulation scenarios comprises three-dimensional model such as geometrically accurate 3D models of the buildings, infrastructure, machinery, equipment, and other relevant assets within the industrial environment. Further, the data comprises asset parameters such as real-time or near real-time data reflecting the current operational status and parameters of the assets. This includes sensor readings (temperature, pressure, flow rates, etc.), performance metrics (production rates, efficiency), control system settings, and maintenance status. Further, the data comprises process flow information such as data describing the operational processes within the environment, such as material flow, energy distribution, and production workflows. Further, the data comprises environmental data such as information about the current ambient conditions within the industrial environmental, such as temperature, humidity, lighting, and potentially air quality. Further, the data comprises spatial relationships such as data defining the physical layout and interconnections between different assets and areas within the industrial environment.

In an example, importing the simulation scenarios comprises retrieving the simulation scenario from a local storage device, a network server, a cloud-based platform that stores simulated scenarios, or directly from a connected digital twin system that provides real-time data from the physical industrial environment for creation of simulation scenarios. For brevity of the disclosure, the generation of simulation scenarios from real-time data is not explained here in detail. The simulation scenarios can be generated by various method known in the art.

At step 304 information pertaining to the operation and behavior of the one or more assets is acquired from one or more large language models for a particular time 't-N' in the past. The method comprises accessing one or more pre-trained Large Language Models (LLMs) to retrieve historical information about the operation and behavior of the particular assets that are represented in the imported simulation scenario. In an example, the large language models include publicly available LLMs comprising general world information of the industrial environment, environmental conditions, industrial regulations, and so on. In another example, the large language model is a local LLM trained on industrial data of a particular entity. The "particular time in the past" can be specified by the user or determined based on predefined criteria. In an example, 't' is year 2025 and the user inputs value of N as 2, the particular time in past would be the year 2023. The interaction with the LLMs involves formulating natural language queries to extract relevant historical data. In an example, information extracted from the LLMs includes historical operating parameters such as typical operating conditions (e.g., average temperature, standard pressure, common production speeds) of specific assets or processes during the chosen past time period (e.g., a specific year, a time range). Further, the information extracted from LLMs includes past performance metrics such as historical production output, efficiency, failure rates, or maintenance frequency of specific assets during that past time. Further, the information extracted form LLMs includes maintenance logs and record providing information about scheduled and unscheduled maintenance activities performed on the assets during the specified past time. Further, the information extracted from LLMs comprises incident reports and anomalies such as records of any operational incidents, equipment malfunctions, or unusual events that occurred during that past time and might have affected asset behavior. Further, the information extracted from LLMs comprises historical environmental conditions within the industrial environment during the chosen past time. The method comprises formulating queries based on the identification of the assets in the imported simulation scenario and the specified past time. The LLMs, having been trained on vast amounts of text and potentially structured data, process these queries and return relevant information, which the processing unit then extracts, structures, and prepares for use in updating the simulation scenario.

At step 306, the operation and behavior of the one or more assets is simulated by updating a first set of simulation parameters determined based on the acquired data, in the imported simulation scenario. Once the historical information is acquired from the LLMs, the method comprises modifying the imported simulation scenario to reflect the state of the industrial environment at the "particular time in the past". This is achieved by updating a first set of simulation parameters within the existing simulation model. The simulation parameters govern how the virtual assets behave and interact within the simulated environment. In an example, the first set of simulation parameters are determined based on adjusting asset properties. The first set of simulation parameters are calculated based on modifications on properties of the 3D models or underlying data representing the assets to reflect their historical specifications or condition (e.g., if a specific piece of equipment was older or had different capabilities in the past) based on the data extracted from the pre-trained LLM. In another example, the first set of simulation parameters are determined based on setting historical operation conditions. The first set of simulation parameters are calculated based on changing the operating parameters of the virtual assets to match the historical values retrieved from the LLMs (e.g., adjusting the default speed of a conveyor belt or the typical temperature of a reactor). In another example, the first set of simulation parameters are determined by incorporating past performance characteristics of the assets. The first set of simulation parameters are calculated by modifying the performance models of the assets to align with historical performance data (e.g., adjusting the simulated efficiency of a power generator based on past records). In another example, the first set of simulation parameters are determined by examining maintenance status of assets. If the historical data indicates that an asset was under maintenance or had recently been repaired at the chosen past time, the simulation might reflect this state. Therefore, the first set of parameters are calculated based on condition and status of assets as in the defined time period or instance. Subsequently, once the first set of simulation parameters are calculated, a historical version of the simulation scenario representing the industrial environment as it was at the specified time in the past is generated.

At step 308, the simulation scenario generated for the particular time in the past is analyzed using the large language model. The analysis is performed on the operating parameters, performance of the assets, and corresponding impact on environmental factors for the time period between the particular time past to the given time in present. With the past simulation scenario generated in step 306, the method further comprises analyzing the operational characteristics, asset performance, and environmental impact over the period spanning from the "particular time in the past" up to the present time (represented by the imported simulation scenario) using the one or more pre-trained large language models. This analysis aims to identify trends, correlations, and potential causal relationships that can inform the prediction of future scenarios. The LLM is provided with data extracted from both the past and present simulation scenarios, and general knowledge about the industry and the specific assets involved. In an example, the analysis comprises identifying performance trends of the one or more assets. Furthermore, the analysis comprises a comprehensive trend analysis on how key operating parameters and asset performance metrics evolve over the defined time period. The trend also indicates in case there were significant improvements, declines, or periods of instability during the defined time period. In another example, the analysis comprises understanding an impact of specific events on the performance of assets, condition of assets, environmental impact of the operation, and so on. The specific events could be equipment upgrades, process modifications, changes in operational policies, change in government policies, change in technology landscape etc. that occurred during this period might have influenced asset performance and an impact on the environment. In another example, the analysis comprises assessing environmental footprint evolution. Herein, it is analyzed how environmental factors such as energy consumption, emissions, and waste generation changed over time, and identifying any correlations with specific operational parameters or asset performance.

The LLM processes this information to generate insights, summaries, and identify patterns or relationships that are not immediately obvious from the data extracted. This analysis serves as a foundation for the subsequent prediction of future scenarios.

At step 310, a second set of simulation parameters are determined corresponding to simulation scenarios for a particular time in future 't+N'' based on the analysis of the past simulation scenarios and one or more requirements from the user, using a generative Al model trained for generating new scenarios based on one or more conditions. This step leverages the insights from the analysis of the simulation scenarios and incorporating one or more requirements specified by the user. The method comprises determining the second set of simulation parameters that will define potential future states of the industrial environment at a "particular time in the future" (or across a future time horizon). The "particular time in the future" can be specified by the user or determined based on predefined criteria. In an example, 't' is year 2025 and the user inputs value of N as 2, the particular time in future would be the year 2027. This method comprises using the generative Al model. Notably, the generative Al model has been specifically trained on a dataset of industrial operational data, simulation parameters, performance outcomes, and environmental impact data, enabling it to generate new, plausible future scenarios based on given conditions and constraints.

In an example, the one or more requirements of the user is at least one of: desired future performance targets such as specific goals for production output, efficiency improvements, or cost reductions, implementation of new technologies such as requests to simulate the impact of introducing new equipment, software, or processes, sustainability goals such as targets for reducing energy consumption, emissions, or waste generation, operational changes such as scenarios involving modifications to existing processes or the introduction of new operational strategies. The second set of simulation parameters are generated using the generative Al model that analyzes the trends and relationships identified in the historical analysis (e.g., how certain parameter changes historically affected performance), along with the user's specified future requirements. The second set of parameters when applied on the simulation scenarios, represent a potential future state of the industrial environment.

At step 312, a plurality of future versions of the simulation scenarios are simulated based on the determined second set of simulation parameters. In order to explore a range of possible future outcomes and to account for uncertainties, the method comprises simulating the plurality of different versions of the future simulation scenario. Each of these versions is based on the second set of simulation parameters determined in the previous step 310, but with slight variations or adjustments. These variations might explore different levels of investment in new technologies, different operational strategies, or different responses to potential future external factors (e.g., changes in market demand, fluctuations in energy prices, or evolving environmental regulations). By generating multiple future scenarios, the method allows the user to visualize a spectrum of potential future states and to assess the potential risks and opportunities associated with different strategic choices.

At step 314, the one or more simulation scenarios are rendered as virtual worlds 104 of the future and the past to be visualized by the user. The method comprises utilizing a rendering engine to transform the generated simulation scenarios - both the one representing the "particular time in the past" and the plurality of "future versions" - into immersive, interactive virtual worlds within the metaverse application. In an example, rendering the scenarios comprises visualizing the 3D models i.e. displaying the 3D models of the industrial environment and its assets according to the parameters defined in each simulation scenario (e.g., changes in layout, appearance of new equipment). Further, rendering also comprises animating asset behavior by simulating the operation of the virtual assets based on second set of simulation parameters and process flows. In an example, the virtual worlds also include displaying data and metrics, such as overlaying or integrating relevant data and performance metrics (e.g., production rates, energy consumption, environmental impact indicators) within the virtual environment in a user-friendly manner. Furthermore, the method comprises enabling the user to navigate through the virtual worlds, inspect assets, access information, and potentially interact with the simulated environment (e.g., by adjusting parameters or triggering events to see the resulting impact).

Advantageously, the rendered virtual worlds104 of the past and the future are presented to the user through the interface of the metaverse application, allowing them to visually experience the temporal evolution of the industrial environment and to gain insights that would be difficult or impossible to obtain through traditional data analysis methods.

In an embodiment, the method of rendering further comprises generating a timelapse experience for the user for a given time period simulating the series of events therebetween. In addition to rendering static virtual world representations for specific points in time, the method further comprises generating a dynamic visualization in the form of a timelapse experience, thereby allowing the user to observe the evolution of the industrial environment over the selected time period (the past time input by the user and the future time input by the user) in an accelerated manner. The method of generating a timelapse experience comprises identifying key events based on the timeline of a selected simulation scenario (e.g., the optimal future scenario or a user-defined timeframe). Further, the method comprises simulating intermediate states of the industrial environment between these key events to create a smooth visual progression. Further, the method comprises generating a sequence of virtual world frames representing these events and intermediate states, and these frames are played back at an accelerated rate to create the timelapse effect.

Advantageously, the timelapse experience provides the user with a high-level overview of the changes and developments that are projected to occur in the industrial environment over the chosen time period, allowing them to quickly understand the overall trajectory and the key milestones along the way.

In an embodiment, the method comprises selecting an optimal future scenario from the plurality of future scenarios based on one or more requirements of the user and a criterion of least negative environmental impact predicted in the optimal simulation scenario. Following the generation of a plurality of future simulation scenarios at step 312, the method comprises identifying the most desirable future state based on a combination of factors: the extent to which the scenarios meet the specific requirements input by the user, and the level of negative environmental impact associated with each scenario. The method comprises implementing a selection process that evaluates each generated future scenario against these criteria.

The one or more requirements defined by the user can encompass a wide range of operational or strategic goals for the industrial environment. In an example, the one or more requirements are at least one of: production targets, cost reduction, efficiency improvements, safety enhancements, specific operational changes, sustainability goals, or a combination thereof. Further, "a least negative impact" is assessed based on one or more predefined metrics. The predefined metrics include at least one of: energy consumption, water usage, carbon (or other harmful gas) emissions, waster generation, resource utilization or a combination thereof. The specific environmental impact metrics considered will depend on the nature of the industrial environment and relevant sustainability goals or regulations. The simulation scenarios generated includes data pertaining to these environmental factors, allowing for their evaluation.

In one example, the optimal future scenarios selection is based on weighted scoring of each of the plurality of future scenarios. The method comprises assigning weights to each user requirement and the environmental impact metric based on their relative importance. Each scenario is then scored based on how well it meets the requirements (potentially normalized to a common scale) and its environmental impact. The scenario with the highest overall weighted score is selected as optimal. In another example, the optimal future scenario selection is based on threshold-based filtering. First, filtering out scenarios that do not meet the minimum acceptable thresholds for all essential user requirements. Then, from the remaining scenarios, selecting the one with the lowest (most favorable) environmental impact. In another example, the optimal future scenario selection is based on multi-objective optimization that comprises treating the user requirements and environmental impact as multiple objectives to be optimized simultaneously. In another example, the optimal future scenario selection is based on rule-based selection. Herein, a predefined set of rules that prioritize certain requirements or environmental impact levels over others are applied to select the optimal future scenario.

The specific selection mechanism can be configured within the metaverse application based on the user's preferences and the priorities of the industrial operation being simulated. Advantageously, identification of a single "optimal" future scenario is selected that best balances the desired operational outcomes with the minimization of negative environmental consequences.

In an embodiment, the method comprises determining a timeline of events within the optimal simulation scenario. The timeline of events corresponds to industrial environment change from the present state to the final optimal future state.

Following the selection of the optimal future scenario, the method comprises analyzing the simulation data associated with the optimal future scenario to identify and order the key events and transitions that occur over the simulated time period. This process involves examining how the simulation parameters of the various assets and the overall industrial environment change from the initial state to the final optimal future state. The timeline of events is determined based on identifying significant parameter changes by detecting substantial alterations in the operating parameters of critical assets (e.g., temperature, pressure, flow rate, efficiency). Further, the timeline of events is determined based on scheduled events by identifying pre-programmed events within the simulation, such as maintenance activities, equipment upgrades, or process modifications that are planned to occur at specific times. Further, the timeline of event is determined based on detecting state transitions by identifying changes in the operational status of assets (e.g., from idle to running, or from normal operation to a fault state). Further, the timeline of events is determined based on ordering event chronologically by arranging the identified parameter changes, scheduled events, and state transitions in the order they occur within the simulated timeframe of the optimal future scenario.

Advantageously, the method outputs a structured timeline that outlines the sequence of key occurrences and their timing, providing the user with a clear understanding of the pathway to the optimal future state as predicted by the simulation. This timeline is presented to the user visually within the metaverse application, for example, as a chronological series of events or a graphical representation on a time axis. In an example, the optimal future scenario is also rendered as a timelapse experience as described earlier.

In an embodiment, the method comprises determining one or more measures and corresponding optimal operating parameters across the timeline of events, which when executed on the real-world industrial data, would yield the output of the optimal future scenario.

The method comprises determining the specific actions or interventions (referred to as "measures") that would need to be taken in the real-world industrial environment to align its trajectory with the simulated optimal future or optimal virtual world 104C. Simultaneously, for each point in the timeline where a significant event or transition occurs, the system identifies the corresponding optimal operating parameters for the relevant assets. The measures are determined by translating simulation changes into real-world actions. For example, for each simulated event (e.g., an equipment upgrade), the system identifies the corresponding real-world tasks required (e.g., procurement, installation, commissioning). Further, the measures are determined by identifying optimal settings. For example, for each point in time, the system extracts the simulated values of key operating parameters for the assets (e.g., temperature setpoints, flow rates, processing speeds) that contribute to the optimal performance in the simulation. Further, the measures are determined by defining specific instructions for the real-world environment. For example, measures are determined by formulating clear and actionable instructions for implementing the measures and setting the optimal operating parameters in the physical plant.

Advantageously, the method bridges the gap between the virtual simulation and the real-world operation, providing a practical guide for achieving the desired optimal future state. The measures and optimal operating parameters can be presented to the user alongside the timeline of events within the metaverse application 102.

In an embodiment, the method comprises generating a project plan for a particular time period. The implementation of the determined parameters and recommended measures within the project plan leads to achieving the state of the optimal future scenario.

Based on the sequence of measures and optimal operating parameters determined across the timeline, the method comprises generating a structured project plan. The project plan provides a framework for implementing the necessary changes in the real-world industrial environment over a defined time period to reach the optimal future state visualized in the metaverse. The project plan is generated by defining tasks for different entities, operators, and users from the sequence of events. Further, each task is assigned with start and end dates of completion based on typical implementation times or user-defined constraints. Further, resource requirements such as personnel, equipment, materials, and financial resources needed are specified for each task. Further, relationships between different tasks (e.g., one task must be completed before another can begin) are defined and the project plan is outlined as a series of tasks to be executed. Once the series of task is created, the project plan outlines the individual or teams responsible for executing each task within the defined time frame.

The resulting project plan is be presented to the user in a standard project management format (e.g., Gantt chart, task list) within the metaverse application 102, providing a clear roadmap for implementing the changes required to achieve the optimal future scenario 104C.

In an embodiment, the method comprises receiving one or more requirements from the user to generate a virtual world for a particular time. This method enables the user to request a virtual world representation of the industrial environment for any specific point in time, not limited to the past or the predicted future scenarios. The one or more requirements from the user specifying a particular time is at least one of: a specific date, a relative time offset from the present. Further, the method comprises simulating the imported simulation scenario with one or more simulation parameters determined for the particular time. Herein, the method comprises accessing the relevant data sources (e.g., historical data from LLMs or databases, the imported present-time simulation data, or data generated from future scenarios) to determine the appropriate values for the simulation parameters that would have been in effect at the specified time. This might involve interpolation or extrapolation of existing data if exact data for the requested time is not available. The method further comprises simulating the industrial environment using the determined simulation parameters, effectively recreating the operational state and behavior of the assets as they were (or are projected to be) at the requested particular time. Further, the method comprises rendering the simulation scenario to the particular user. The simulated scenario for the particular time is rendered as a virtual world 104 within the metaverse application 102, allowing the user to visualize the plant and its assets at that specific moment in time.

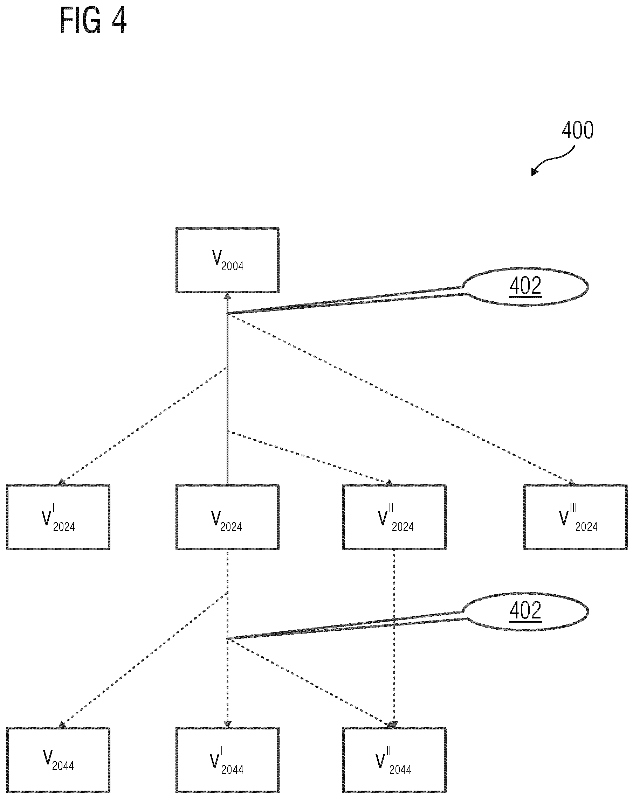

Referring to FIG 4, illustrated is a representation of different versions of virtual worlds 400 created based on user inputs, according to an embodiment of the present invention. As shown, the solid boxes denote the actual metaverse models or virtual worlds, e.g., V₂₀₂₄ is the present metaverse space and V₂₀₀₄ is the metaverse space from 20 years in the past created by the disclosed method based on the user input 402. The dashed boxes denote variations of virtual worlds which are generated using user inputs (e.g., different operating parameters) The different virtual worlds created in the present are denoted by V'₂₀₂₄, V"₂₀₂₄ , and V‴₂₀₂₄. Every branch is created when a user provides a different input. Similarly, when the user provides the input 402 for creating different future scenarios for the time period 2044, different future virtual worlds are created, represented here as V₂₀₄₄, V'₂₀₄₄ , and V"₂₀₄₄ which are generated based on user inputs using the generative Al model.

Advantageously, this on-demand visualization capability provides the user with the flexibility to explore the industrial environment at any point of interest across its temporal evolution in the computer simulated environment 102.

In an embodiment, the method comprises storing the generated scenarios in a database 220 indexed with time and corresponding operation parameters for the given time.

The method comprises storing the generated future simulation scenarios or virtual worlds 104 in a database 220 to facilitate efficient management, retrieval, and comparison of the various generated simulation scenarios. Each stored virtual world 104 is associated with metadata that includes a time identifier and operating parameters corresponding to the virtual world 104. Notably, each virtual world 104 is stored with a timestamp or a representation of the specific point in the future (or a future time range) that the virtual world represents. Furthermore, each virtual world 104 is stored with specific values or configurations of the key operational parameters of the assets and the overall industrial environment that define that particular scenario. This could include settings for machinery, process parameters, resource allocation, etc.

The database 220 is structured and indexed using these metadata elements (time and operation parameters) as primary keys or indexing attributes. This indexing allows users or the system itself to quickly search for and retrieve specific simulation scenarios based on the time they represent or the operational characteristics they embody. For example, a user might want to retrieve all future scenarios or virtual worlds 104 projected for the year 2030 or all scenarios that involve a specific level of automation.

In an embodiment, the method comprises storing different versions of generated simulation scenarios or different virtual worlds 104 created by different users, wherein each version is associated with user credentials and is accessible to the corresponding user.

The method comprises storing and managing user-specific versions of the generated simulation scenarios or virtual worlds 104 in order to facilitate collaboration, individual exploration, and the management of diverse perspectives on the future and past of the industrial environment.

The method comprises authenticating users who interact with the metaverse application. The method comprises standard authentication methods such as username/password combinations, multi-factor authentication, or integration with existing identity management systems. Once a user is authenticated, they are assigned a unique user identifier or set of credentials that the system uses to track their activities and associated data.

When a user initiates the process of generating a future or past simulation scenario or virtual worlds 104 (as described in the preceding claims), the method comprises automatically associating the resulting simulation data and the corresponding virtual world with the authenticated user's credentials. This association is maintained throughout the lifecycle of the scenario. For example, when the user saves a generated scenario (or virtual world 104) or modifies an existing one, the method comprises recording their user identifier along with the scenario data.

The generated simulation scenarios or virtual worlds 104, along with their associated operational parameters and temporal information, are stored in a database or other suitable data storage system. The storage mechanism is designed to maintain a clear link between each scenario and the user who created it. This can be achieved by including the user's unique identifier as a field within the data record for each scenario, or by organizing the scenarios into user-specific directories or namespaces within the database.

Furthermore, to ensure that user-specific versions of the simulation scenarios or virtual worlds 104 are accessible only to the corresponding user (or potentially to other users explicitly granted permission), the method comprises introducing an access control mechanism. This mechanism governs who can view, modify, delete, or share specific simulation scenarios or virtual worlds 104. In an example, the access mechanism employed is role-based access control. This mechanism comprises Assigning roles to users (e.g., Plant Manager, Engineer, Guest) and defining permissions for each role. The scenarios or virtual worlds 104 created by a user might be automatically assigned permissions based on their role, with the creator having full access. In another example, the access mechanism employed is based on user-based permissions. This mechanism comprises directly associating permissions with individual user accounts. For example, a user might have exclusive access to the scenarios or virtual worlds 104 they create but could optionally grant read or write access to specific other users. In another example, the access mechanism employed is based on group-based permissions. This mechanism comprises allowing users to be organized into groups with shared access rights to certain scenarios.

The access control mechanism is enforced whenever a user attempts to access or manipulate a stored simulation scenario or virtual world 104. The method comprises verifying the user's credentials and checking if they have the necessary permissions to perform the requested action on that specific scenario or virtual world 104.

Advantageously, the method aims to provide a personalized exploration experience to users by allowing them to freely explore different future possibilities and hypotheses without affecting the scenarios created by other users. Furthermore, users can create their own versions, refine them, and then selectively share them with other stakeholders for review or collaboration. Moreover, it allows for the existence of multiple versions of a simulation scenario, potentially representing different stages of analysis or different sets of assumptions made by various users. Notably, the association of scenarios with specific users provides an audit trail of who created and modified each version.

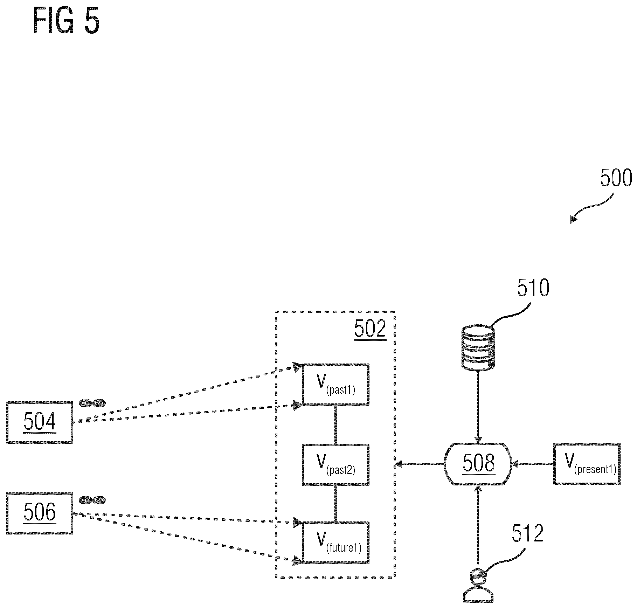

Referring to FIG 5, illustrated is a workflow of management of different version of the simulated virtual worlds 500, according to an embodiment of the present invention. As shown, different versions of the virtual worlds are managed by the version management module 502 which is then rendered to different users 504, 506 on request. The different versions of the virtual worlds in the past, present and future are generated by the generative Al model 508 using the data acquired from the large language model 510. For example, as shown, the present virtual world V₍ₚᵣₑₛₑₙₜ₎ is modified based on user inputs 512 to generate different virtual worlds in the past represented as V₍ₚₐₛₜ₁₎ V₍ₚₐₛₜ₂₎ and in the future represented as V_{(future1)}.

Referring to FIG 6, illustrated is an exemplary architecture of the system 600 for generating one or more virtual worlds for transtemporal experience in a computer simulated environment 102. The system 600 comprises a metaverse model 602 (past/future scenarios) and metaverse model 604 (present scenario) that is rendered to a user 606 via a user device 608 such as an AR/VR device. The metaverse model 602, 604 (also referred to as virtual worlds) are virtual representation of a real-world location like a factory or shop floor. The metaverse model comprises of the 3D model, live sensor data, environmental data, haptic data, behavioural data, human avatars, etc. Furthermore, the metaverse model comprises multiple individual models like CNC machines, human avatars, etc. The system 600 further comprises pre-trained large language model (LLM) 610 that comprises all general world data such as news articles, market reports, encyclopaedias, research papers, machine datasheets, etc. Furthermore, the large language model (LLM) 610 also comprises industrial data corresponding to the industrial environment, asset data, operations, data, supply chain data, weather reports, geological surveys, census records, factory personnel data, customer sales records, etc., which is used to generate different scenarios based on user input. Further, the system 600 comprises a generative Al model 612 configured to generate new content based on existing data. For a given metaverse model or virtual world, the generative Al model 612 is configured to generate different versions based on different parameters and one or more user requirements. For example, it can generate a representation of how a factory location looked a 100 years ago. This relies on the data from the large language model 610. Using the personnel records from 20 years ago, it can generate avatars for the employees. Using the sales records, it can generate the machinery models which would have been required to create the components in the sales record. Using the electricity bills and weather data, it can simulate the operations of fans, ACs, heaters, etc. The system further comprises a database 614 that stores different content or models generated by GenAl model 612, indexed by time and operational parameters. For example, the same CNC machine may have different models for the next year based on operating conditions. The system 600 further comprises a version management module 616 configured to manage different versions pertaining to each metaverse model or virtual world. Each version is indexed and identified by the 'time' and operational attributes. It can also create composite metaverse models MMs from individual models, e.g., it can create the model of a shop floor from the models of 20 CNC machines. The system 600 further comprises a rendering module 618 configured to render a specific version of the virtual world or the metaverse model. The rendering module 618 is also configured to generate timelapse experiences by rendering different versions ordered by time.

In an exemplary implementation, the large language model (LLM) 610 is trained based on publicly available data relevant for the industrial environment including public records like weather, population surveys, newspapers, etc and private information specific to the plant or factory such as personnel data, sales data, etc. This is also used by the generative Al model 612 to generate content. The metaverse model (MM) 602, or the virtual worlds is created by replicating the simulation model 604 in present time. It can be a simple model like a CNC machine or a composite model like a shop floor which can consist of multiple simple models. This can involve multiple steps like design, review, implementation, etc. Further, the generative Al model 612 takes this model as an input and generates multiple versions based on time, using the large language model 610 and user input. It should be understood that there can only be one true past model for a time period, but the future may have multiple models for the same time. For example, in case of the thermal plant, the future where the plant shuts down now and the future where the plant shuts down after 10 years are different. Multiple simulations can be created based on specified parameters. However, we also create multiple "false" past models based on decisions which "could have been taken", as shown in figure 4. This can be used to validate the decisions of the past. The different models are stored in the database 614. The different versions are managed by version management module 616, indexed by time and operating parameters. The user can select from an existing version to be rendered in the metaverse. An access control mechanism is employed to regulate who can access specific models. The user can also generate specialized versions based on specific inputs. These are stored inside the database 614. The selected version is generated from individual models fetched from the database 614 and rendered in the metaverse using the rendering module 618. This system aims at creating transtemporal experiences in the industrial metaverse using generative Al model 612. With a representation of the present in the industrial metaverse, generative Al model 612 is utilized to create the same representation in the past and the future.

There could be several possible implementations and use cases of the described invention. For the brevity of the disclosure, only few of them are described here as examples.

In an example, let us consider an industrial shop floor. We have all the requisite data for the present like personnel, machinery, BOM, 3D models, simulation data, etc. This data would be sufficient to re-create the shop floor in the metaverse. Now let us say we wish to visualize the shop floor from 20 years ago. The information required may no longer be available. However, we might have some old data like personnel records, sales records, customer bills, etc. The method would utilize this fragmented data and the metaverse space from the present to envision the shop floor from 20 years ago and render it to the user. In another example, from the shop floor model of 20 years ago, we can generate multiple versions based on different decisions. These can be used to validate the decisions which were actually taken to reach the present, e.g., we can prove that the decisions are within the top 10% of the optimum. In another example, immersive presentations to executives, regulators and government authorities can be made to convey the functioning of factories and other parameters like environmental impact. The functioning of the factory in the past, present and future can be demonstrated in an intuitive manner to non-technical audience. In another example, the sustainability metrics of different versions is determined (based on carbon emissions, personnel transport emissions, raw material procurement, etc.) and presented to the authorities responsible for decision making. This can then be utilized to take better informed decisions to reduce the environmental emissions. In yet another example, different scenarios based on different optimizations can be simulated for the future, which can then be analysed and demonstrated to the users. The most efficient scenario can be followed to optimize the plant operations. Furthermore, this invention enables non-experts to visualize the past of a factory and also the future effects of major decisions. As such, it can be used by the upper management to understand the implications of their decisions without the need for deep technical knowledge.

While the invention has been illustrated and described in detail with the help of a preferred embodiment, the invention is not limited to the disclosed examples. Other variations can be deducted by those skilled in the art without leaving the scope of protection of the claimed invention.

### List of references

- 100: system
- 102: digital twin
- 104A, 104B, 104C: plurality of virtual worlds
- 106: communication network
- 108: apparatus
- 202: one or more processing units
- 204: memory unit
- 206: module
- 208: scenarios importing module
- 210: data collection module
- 212: data analysis module
- 214: simulation module
- 216: rendering module
- 218: storage unit
- 220: database
- 222: input unit
- 224: output unit
- 226: bus
- 300: flowchart of a method for generating one or more virtual worlds 104 for transtemporal experience in a computer simulated environment
- 400: different versions of virtual worlds
- 402: user input
- 500: a workflow of management of different version of the simulated virtual worlds
- 502: version management module
- 504, 506: different users
- 508: generative Al model
- 510: large language model
- 512: user inputs
- 600: exemplary architecture of the system for generating one or more virtual worlds for transtemporal experience in a computer simulated environment
- 602: metaverse model/simulation scenarios of past/future
- 604: metaverse model/simulation scenarios of present
- 606: user
- 608: user device
- 610: large language model
- 612: generative Al model
- 614: database
- 616: version management module
- 618: rendering module

## Claims

1. A method (300) for generating one or more virtual worlds (104A, 104B, 104C) for transtemporal experience in a computer simulated environment (102), the method comprising:
importing, by a processing unit (202), a simulation scenario (604) pertaining to operation and behavior of one or more assets in an industrial environment, wherein the simulation scenario comprises data acquired for a present time 't';
acquiring, by the processing unit (202), information pertaining to the operation and behavior of the one or more assets from one or more large language models (510, 610) for a particular time 't-N' in the past;
simulating, by the processing unit (202), the operation and behavior of the one or more assets by updating a first set of simulation parameters determined based on the acquired data, in the imported simulation scenario (604);
analyzing, by the processing unit (202), the simulation scenario generated for the particular time in the past, wherein the analysis is performed on the operating parameters, performance of the assets, and corresponding impact on environmental factors for the time period between the particular time past to the given time in present using the large language model (510, 610);
determining, by the processing unit (202), a second set of simulation parameters corresponding to simulation scenarios for a particular time in future 't+N'' based on the analysis of the past simulation scenarios and one or more requirements from a user (504, 506, 606), using a generative Al (508, 612) model trained for generating new scenarios based on one more conditions;
simulating, by the processing unit (202), plurality of future versions of the simulation scenarios based on the determined second set of simulation parameters; and
rendering, by the processing unit, the one or more simulation scenarios as virtual worlds (104A, 104B, 104C) of the future and the past to be visualized by the user (504, 506, 606).

2. A method (300) according to claim 1, further comprises selecting an optimal future scenario from the plurality of future scenarios based on one or more requirements of the user (504, 506, 606) and a criterion of least negative environmental impact predicted in the optimal simulation scenario.

3. A method (300) according to claim 2, further comprises determining a timeline of events within the optimal simulation scenario, wherein the timeline of events correspond to industrial environment change from a present state to a final optimal future state.

4. A method (300) according to claim 3, further comprises determining one or more measures and corresponding optimal operating parameters across the timeline of events, which when executed on the real-world industrial data, would yield the output of the optimal future scenario.

5. A method (300) according to claim 4, further comprising generating a project plan for a particular time period, wherein implementation of the determined parameters and recommended measures within the project plan leads to achieving the state of the optimal future scenario.

6. A method (300) according to any of the preceding claims, further comprising:
receiving one or more requirements from the user (504, 506, 606) to generate a virtual world (104) for a particular time;
simulating the imported simulation scenario with one or more simulation parameters determined for the particular time; and
rendering the virtual world based on the simulation scenario (104) to the particular user (504, 506, 606).

7. A method (300) according to any of the preceding claims, further comprising storing the generated simulation scenarios in a database (220, 614) indexed with time and corresponding operation parameters for the given time.

8. A method (300) according to any of the preceding claims, wherein rendering further comprises generating a timelapse experience for the user (606) for a given time period simulating the series of events therebetween.

9. A method (300) according to any of the preceding claims, further comprises storing different versions of generated virtual worlds (104) created by different users (504, 506, 606), wherein each version is associated with user credentials and is accessible only to the corresponding user.

10. An apparatus (108) for generating one or more virtual worlds for transtemporal experience in a computer simulated environment, the apparatus (108) comprising:
one or more processing units (202); and
a memory (204) communicatively coupled to the one or more processing units (202), the memory (204) comprising a module (206) stored in the form of machine-readable instructions executable by the one or more processing units (202), wherein the module (206) is configured to perform the method (300) steps according to claims 1 to 9.

11. A system (100) for generating one or more virtual worlds for transtemporal experience in a computer simulated environment, the system comprising:
a computer simulated environment (102) hosting a plurality of virtual worlds (104), wherein each of the virtual worlds correspond to a version of operation of one or more assets in an industrial environment at a given point in time; and
an apparatus (108) according to claim 10, communicatively coupled to the computer simulated environment, wherein the wherein the apparatus (108) is configured for generating one or more virtual worlds across for transtemporal experience in a computer simulated environment, according to any of the method claims 1 to 9.

12. A computer-program product, having computer-readable instructions stored therein, that when executed by a processing unit (202), cause the processing unit (202) to perform method (300) steps according to any of the claims 1 to 9.
